# EUROPÄISCHE PATENTSCHRIFT

(11) **EP 1 675 155 B1**
(45) Veröffentlichungstag und Bekanntmachung des Hinweises auf die Patenterteilung: **25.01.2012**
(21) Anmeldenummer: 04030764.7
(22) Anmeldetag: 24.12.2004
(51) Int. Cl.: H01J 37/32

(54) **Plasmaanregungssystem**
Plasma excitation system
Système d'excitation de plasma

(43) Veröffentlichungstag der Anmeldung: 28.06.2006
(73) Patentinhaber: HÜTTINGER Elektronik GmbH + Co. KG, 79111 Freiburg (DE); ULVAC, INC., Chigasaki-shi, Kanagawa 253-8543 (JP)
(72) Erfinder: Trusch, Alfred, 79206 Breisach (DE); Bannwarth, Markus, 79115 Freiburg (DE); Wolf, Lothar, 79361 Sasbach (DE); Steuber, Martin, 79426 Buggingen (DE); Axenbeck, Sven, 79395 Neuenburg (DE); Wiedemuth, Peter, Dr., 79336 Herbolzheim (DE)
(74) Vertreter: Kohler Schmid Möbus

(56) Entgegenhaltungen:
- DE-A1- 4 326 100
- DE-A1- 4 441 206
- DE-A1- 19 610 012
- US-A- 5 423 970
- US-A1- 2004 089 535
- US-A1- 2004 165 324
- US-B1- 6 340 416
- HÜTTINGER: "MF-Generator BIG 100/10" TECHNISCHE SPEZIFIKATION, [Online] 13. September 2004 (2004-09-13), XP002327954 Gefunden im Internet: URL:HTTP://WWW.TRUMPF.COM/SCRIPTS/HUETTING ER/123.IMG-CUST/BIG_100-10_SD.PDF> [gefunden am 2004-09-13]

## Beschreibung

Die Erfindung betrifft ein Plasmaanregungssystem zur Leistungsversorgung eines Plasmaprozesses mit zumindest einer an einen Netzanschluss anschließbaren DC-Stromversorgung und zumindest einer damit verbundenen Mittelfrequenz (MF) - Einheit zur Erzeugung einer AC-Spannung an ihrem Ausgang, wobei der Ausgang der MF-Einheit an Elektroden einer Beschichtungskammer anschließbar ist, und mit einer Regel- und/oder Steuereinrichtung, die mit der zumindest einen DC-Stromversorgung zur Regelung und/oder Steuerung einer Ausgangsgröße der DC-Stromversorgung verbunden ist und die mit der zumindest einen MF-Einheit zur Regelung und/oder Steuerung einer Ausgangsgröße der MF-Einheit verbunden ist.

Bei Flatpaneldisplay (FPD) Herstellungsprozessen werden große Flächen von Substrat, z.B. Glasscheiben, gleichmäßig in mehreren Schritten beschichtet. Die Beschichtung von großen Glasflächen mittels Sputtern/Kathodenzerstäuben in Plasmaprozessen, und zwar sowohl reaktiv als auch konventionell, ist aus der Architekturglasbeschichtung bekannt. Dazu wird mit einer Strom- oder Spannungsquelle ein Plasma erzeugt, das von einem Target Material abträgt, welches sich auf dem Substrat, z.B. der Glasscheibe, ablagert. Vor der Ablagerung können sich die Atome je nach gewünschter Beschichtung in einem reaktiven Prozess noch mit Gasatomen oder -molekülen verbinden.

Bei der Architekturglasbeschichtung werden die Glasscheiben in der Plasmakammer (Beschichtungskammer) kontinuierlich an einer Sputterquelle vorbeigeführt und wird die Beschichtung somit gleichmäßig aufgetragen. Dazu muss die Plasmaverteilung in nur einer Achse, also eindimensional, nämlich senkrecht zur Bewegungsrichtung des Substrats, homogen sein.

Bei der Architekturglasbeschichtung werden sowohl DC- als auch Mittelfrequenz (MF)-Sputterprozesse verwendet. Letztere werden mit (MF)-Stromversorgungen betrieben. Dabei wird aus einer Ein- oder Mehrphasenspannung eine geregelte oder ungeregelte Zwischenkreisspannung erzeugt. Die Zwischenkreisspannung wird mit einer Inverterschaltung (z.B. Brückenschaltung) zu einer Mittelfrequenz (MF)-Wechselspannung umgewandelt (10-500kHz). Das MF-Ausgangsleistungssignal wird auf einen Schwingkreis geschaltet, der zu einer Schwingung angeregt wird. Der Schwingkreis kann ein Serienschwingkreis oder ein Parallelschwingkreis sein. Ein Serienschwingkreis wird mit einem Ausgangsleistungssignal mit einer Spannungsquellencharakteristik angeregt, wohingegen der Parallelkreis mit einem Ausgangsleistungssignal mit einer Stromquellencharakteristik angeregt wird.

Üblicherweise wird die MF-Leistung an der Spule des Schwingkreises ausgekoppelt und an zwei Elektroden in einer Beschichtungskammer einer Beschichtungsanlage angeschlossen, so dass in der Beschichtungskammer ein Plasma erzeugt werden kann. Die Elektroden arbeiten bei einem MF-Anregungssystem abwechselnd als Anode und Kathode.

Bei FPD Herstellungsprozessen werden aufgrund ihrer Größe die Substrate flächig beschichtet ohne dass die Substrate bewegt werden. Da ein relativ großes Substrat von einigen Quadratmetern bis zu mehreren 10qm in der vollen Fläche gleichzeitig beschichtet wird und die Ausfallrate sehr gering sein muss, da ein FPD nicht aus mehreren Teilen zusammengesetzt werden kann, ergeben sich neue Anforderungen an die Anlagen, an die Plasmakammern, Elektroden, Targets und letztlich auch an die Stromversorgungen.

Bei der FPD Herstellung werden bislang ausschließlich DC-Stromversorgungen zur Anregung des Plasmas eingesetzt. Dies hat mehrere Gründe: Da die Substrate wegen ihrer Größe schlecht handhabbar sind, können diese während der Beschichtung nicht bewegt werden. Die Plasmaverteilung muss daher zweidimensional, also über die gesamte Fläche des Substrats, sehr homogen sein. Dies wurde bislang nur mit DC Spannungsquellen erreicht.

Zur Beschichtung der gesamten Fläche in einem Arbeitschritt sind sehr viel höhere Leistungen erforderlich. Die FPD Herstellprozesse benötigen zur Plasmaerzeugung Stromversorgungen mit Leistungen von 50 bis 200kW und mehr. Dabei sollen die Stromversorgungen ohne großen Aufwand zwischen den einzelnen Leistungsklassen umkonfigurierbar sein, also z.B. von 50kW auf 100kW. Auch das lässt sich mit DC Stromversorgungen sehr viel einfacher realisieren als mit MF Stromversorgungen. Bei DC-Plasmaprozessen ist es bekannt mehrere DC-Anregungssysteme parallel zusammenzuschalten und eine gemeinsame Regelung vorzusehen, die dafür sorgt, dass alle Plasmasysteme die gleiche Leistung abgeben.

Da Stromversorgungen mit einem endlichen Wirkungsgrad arbeiten, erzeugen diese nennenswerte Verlustwärme, die abgeführt werden muss. Üblicherweise werden die Stromversorgungen mit Kühlflüssigkeit gekühlt. In der unmittelbaren Nähe der Beschichtungskammern zur FPD Herstellung stehen aber nur begrenzt Kühlflüssigkeiten zur Verfügung. Luftgekühlte DC-Stromversorgungen sind bekannt, MF-Stromversorgungen werden derzeit wegen der großen Verluste in der MF-Einheit immer noch mit Kühlflüssigkeit gekühlt.

Um platzsparend arbeiten zu können werden die unterschiedlichen erforderlichen Beschichtungsprozesse, die zeitlich nacheinander verlaufen, alle in derselben Beschichtungskammer durchgeführt. Dazu wird Material von unterschiedlichen Targets abgetragen. Um dieselbe Stromversorgung für unterschiedliche Beschichtungsprozesse verwenden zu können, ist es vorteilhaft, wenn eine Stromversorgung von einem Target auf ein anderes Target umgeschaltet werden kann. Dies ist bei DC-Stromversorgungen einfach realisierbar, bei MF-Stromversorgungen ist das nur mit großem Aufwand möglich, was zusätzlich gegen die Verwendung von MF-Stromversorgungen bei der Beschichtung von großen Substraten spricht.

Für die Verwendung von DC-Stromversorgungen spricht weiterhin, dass für Beschichtungsanlagen oft wenig Platz zur Verfügung steht. Stromversorgungen werden daher häufig an entfernt gelegenen Orten, beispielsweise im Keller, aufgestellt und die Stromzufuhr erfolgt über relativ lange Kabel. Diese Lösung ist für DC-Stromversorgungen relativ einfach umzusetzen, da DC-Kabel kostengünstig und flexibel sind.

DC-Stromversorgungen haben jedoch den Nachteil, dass sie insbesondere bei reaktiven Prozessen zu Überschlägen (Arcs) neigen, weil die Targets ungleichmäßig abgetragen werden und sich isolierende Schichten auf den Targets bilden.

Aus der DE 43 26 100 A1 ist ein Plasmaanregungssystem bekannt, das einen MF-Generator aufweist, der über ein Koaxialkabel mit den Elektroden einer Beschichtungskammer verbunden ist. Strom und Spannung werden über eine Messwerterfassungseinrichtung erfasst. Diese steht mit einer Steuerung des MF-Generators in Verbindung.

Aus der Beschreibung des MF-Generators BIG 100/10, im Internet unter http://www.trumpf.com/scripts/huettinger/123.img-cust/big_100-10_sd.pdf, 13.09.04, ist es bekannt, einen MF-Generator mehrteilig aufzubauen. Dabei kann ein Gleichstrom geregelt werden.

Die US 2004/089535 A1 offenbart eine Plasmabeschichtungsanlage, mit der große Flächen beschichtet werden können. In der Plasmaanlage sind mehrere gepulste DC-Magnetrons angeordnet, die von einer Plasmaanregungsanordnung angesteuert werden.

Aufgabe der vorliegenden Erfindung ist es, ein verbessertes Plasmaanregungssystem für die Beschichtung von großflächigen Substraten bereit zu stellen.

Diese Aufgabe wird erfindungsgemäß durch ein Plasmaanregungssystem mit den Merkmalen des Anspruchs 1 gelöst. Die zumindest eine Eingangsschnittstelle dient zur Zuführung einer eine Ausgangsgröße der zumindest einen MF-Einheit beschreibenden Größe. Die zumindest eine Steuerausgangsschnittstelle dient zum Anschluss eines Steuereingangs der zumindest einen MF-Einheit. Die Ausgangsgröße der MF-Einheit kann der Regel- und/oder Steuereinrichtung direkt zugeführt werden. Dabei ist die die Ausgangsgröße beschreibende Größe die Ausgangsgröße selbst. Es ist auch denkbar, dass die Ausgangsgröße durch eine Messeinrichtung erfasst wird, die die Ausgangsgröße oder eine diese beschreibende Größe an die Regel- und/oder Steuereinheit mittels der Eingangsschnittstelle übergibt. Es können mehrere Eingangs- und Steuerausgangsschnittstellen an der Regel- und/oder Steuereinrichtung vorgesehen sein, so dass an diese mehrere MF-Einheiten angeschlossen werden können.

Strom, Spannung und/oder Leistung des MF-Ausgangssignals wird also gemessen und geregelt. Die Regel- und/oder Steuereinrichtung kann somit auf die MF-Einheit zugreifen. Durch die Bereitstellung zumindest einer Eingangsschnittstelle und zumindest einer Steuerausgangsschnittstelle ist es nun möglich, die DC-Stromversorgung an mehrere MF-Einheiten gleichzeitig anzuschließen. Je nach Regelung/Steuerung wird dann Leistung nur an einzelne MF-Einheiten abgegeben, insbesondere nur an die, für die es erwünscht ist. Zur Abschaltung bzw. Nichtverwendung einer einzelnen MF-Einheit sind daher keine DC-Leistungsschalter notwendig. Da die MF-Einheiten in der Regel Schaltbrücken enthalten, genügt es, die MF-Einheiten bzw. Inverter, die in denen Schaltbrücken angeordnet sind, so anzusteuern, dass alle Schalter geöffnet sind. Durch den Inverter wird in diesem Fall keine Leistung übertragen. Damit lassen sich unterschiedliche Prozesse, insbesondere mit unterschiedlichen Targets, mit einer gemeinsamen DC-Stromversorgung betreiben. Nur die MF-Einheit, die auch auf jedes Elektrodenpaar abgestimmt sein muss, ist für jedes Elektrodenpaar jeweils einmal vorhanden.

Durch das Bereitstellen der oben genannten Schnittstellen ist es vorteilhafterweise möglich, DC-Stromversorgungen und MF-Einheiten in unterschiedlichen Gehäusen unterzubringen. Damit können störende Interferenzen vermieden werden.

Bei einer bevorzugten Ausführungsform weist die Regel- und/oder Steuereinrichtung zumindest eine weitere Eingangsschnittstelle und zumindest eine weitere Steuerausgangsschnittstelle auf. Die zumindest eine weitere Eingangsschnittstelle dient zur Zuführung einer Ausgangsgröße oder einer eine Ausgangsgröße der zumindest einen DC-Stromversorgung beschreibenden Größe. Die zumindest eine Steuerausgangsschnittstelle dient zum Anschluss eines Steuereingangs der zumindest einen DC-Stromversorgung. Das Plasmaanregungssystem besteht somit aus zumindest einer DC-Stromversorgung und einer MF-Einheit, wobei die DC-Stromversorgung an ihrem (Leistungs-) Ausgang eine Zwischenkreisspannung erzeugt, die der MF-Einheit zugeführt wird. Die Regel- und/oder Steuereinrichtung kann Strom, Spannung und/oder Leistung am Ausgang der DC-Stromversorgung mittelbar über entsprechende Messeinrichtungen oder unmittelbar messen und regeln. Es wird somit nicht (nur) die Ausgangsgröße der MF-Einheit für die Regelung und Steuerung des Plasmabeschichtungsprozesses verwendet sondern bereits die Ausgangsgröße der DC-Stromversorgung.

Durch das Vorsehen der beschriebenen Schnittstellen können mehrere DC-Stromversorgungen auf einfache Art und Weise an die Regel- und/oder Steuereinrichtung angeschlossen werden. Vorteilhafterweise können Strom, Spannung und Leistung am Ausgang der MF Einheit wahlweise geregelt werden. Damit ist es möglich, das Anregungssystem an den jeweiligen Plasmaprozess optimal anzupassen.

Vorteilhaft ist es weiterhin, wenn die Regel- und/oder Steuereinrichtung Schnittstellen zum Anschluss von Daten- und/oder Signalleitungen aufweist, die mit der zumindest einen DC-Stromversorgung und/oder der zumindest einen MF-Einheit in Verbindung stehen. Signale, beispielsweise einer Arc-Erkennungseinrichtung, können somit schnell und einfach an die Regel- und/oder Steuereinrichtung übermittelt werden, die dann darauf reagieren kann. Die Datenleitungen dienen zum Austausch von Daten und Signalen zwischen der MF-Einheit und der Regel- und/oder Steuereinrichtung bzw. einer Master-DC-Stromversorgung. Die Datenübertragung kann für Mess- und Regelsignale, die sehr schnell übermittelt werden müssen, wie etwa Daten der Leistungsmessung, analog erfolgen. Vorzugsweise erfolgt der Datenaustausch über Stromschnittstellen und nicht über Spannungsschnittstellen, da so die Störempfindlichkeit verbessert werden kann. Die Übertragung von Steuer- Mess- und Regelsignalen, die relativ schnell und mit einer hohen Datensicherheit übertragen werden müssen, wie etwa die Arc-Erkennung beschreibende Signale, Fehlerzustände, etc. kann digital erfolgen. Die digitale Datenübertragung kann über einen seriellen Kommunikationsbus (z.B. CAN) für Signale erfolgen, bei denen es auf sehr hohe Datenzuverlässigkeit ankommt, die aber weniger zeitkritisch sind, z.B. Signale einer Temperaturüberwachung.

Bei einer Ausgestaltung der Erfindung ist die zumindest eine DC-Stromversorgung von der zumindest einen MF-Einheit entfernt angeordnet, insbesondere im Bereich von 1 - 50m entfernt, und mit dieser durch ein DC-Kabel und Mess- und Steuerleitungen verbunden. Die DC-Stromversorgung muss nicht in unmittelbarer Nähe der Plasmaanlage bzw. Beschichtungskammer stehen. Die Stromversorgung beansprucht daher keinen Platz in einer Fertigungshalle. Die MF-Einheit alleine ist leichter als die Gesamtheit aus Stromversorgung und MF-Einheit und kann somit auch in einer unterkellerten Halle aufgestellt werden. Vorteilhafterweise kann die Stromversorgung in diesem Fall unter der MF-Einheit angeordnet werden. Die DC-Kabel sowie Steuer- und Messkabel können über erhebliche Entfernungen zu den MF-Einheiten geführt werden, die in unmittelbarer Nähe der Beschichtungskammer stehen, und dort über entsprechende Schnittstellen verbunden werden. Das ist vorteilhaft, weil keine teuren MF-Kabel verwendet werden müssen, die in ihrer Länge beschränkt und zudem starrer als die DC-Kabel sind.

Bei einer bevorzugten Ausgestaltung der Erfindung ist die zumindest eine DC-Stromversorgung luftgekühlt. Die zumindest eine MF-Einheit kann dann kühlflüssigkeitsgekühlt oder luftgekühlt sein. Wenn nur die MF-Einheit mit Kühlflüssigkeit gekühlt wird, wird weniger Verlustwärme an die Kühlflüssigkeit abgegeben. Kühlflüssigkeit ist in unmittelbarer Nähe der Beschichtungskammer, bei der auch die MF-Einheit steht, eher vorhanden als örtlich entfernt, z.B. im Keller. Die DC-Stromversorgung ist wegen der Luftkühlung unabhängig von einem Kühlmittelanschluss und damit an beinahe jedem beliebigen Ort aufstellbar.

Bei einer bevorzugten Ausführungsform der Erfindung weist die zumindest eine MF-Einheit zumindest einen ersten Inverter zur Speisung eines Ausgangsschwingkreises auf. Der Ausgangsschwingkreis kann als Serien- oder Parallelschwingkreis ausgebildet sein. Um eine Stromquellencharakteristik zu erreichen, können am Eingang des Inverters Drosseln vorgesehen sein. Durch den Inverter wird dabei eine Wechselspannung aus einer Zwischenkreisspannung erzeugt. Der Inverter ist vorzugsweise als Vollbrücke, insbesondere als Vollbrücke mit gesteuerten IGBTs, ausgebildet. Die MF-Einheit kann weiterhin eine Steuerung für einen oder mehrere Inverter aufweisen. Die Spule des Ausgangsschwingkreises kann die Streuinduktivität auf der Primärseite eines Ausgangsübertragers darstellen. Der Ausgangsübertrager kann so ausgelegt sein, dass er eine galvanische Trennung zwischen Ausgangsschwingkreis und Elektroden in der Plasmakammer realisiert. Dann brauchen weder die DC-Stromversorgung noch der Inverter mit einer galvanischen Trennung ausgestattet zu werden. Der Ausgangsübertrager kann als Luftspule ausgeführt sein, dann kommt es zu keiner Sättigung. Der Ausgangsübertrager kann mit mehreren Abgriffen an seinem Ausgang versehen sein, dann können die Spannung und der Strom an die jeweilige Elektrodenanordnung angepasst werden.

In vorteilhafter Ausgestaltung der Erfindung sind mehrere an einen Netzanschluss anschließbare parallel geschaltete DC-Stromversorgungen zur Erzeugung einer ersten Zwischenkreisspannung vorgesehen, die mit dem ersten Inverter der MF-Einheit verbunden sind. Durch die Verwendung mehrerer paralleler DC-Stromversorgungen können durch Zu- oder Abschalten einzelner Stromversorgungen unterschiedliche Leistungsklassen eingestellt werden.

Besonders vorteilhaft ist es, wenn jeder DC-Stromversorgung eine Messeinrichtung zur Messung von Strom, Spannung und/oder Leistung am Ausgang der jeweiligen DC-Stromversorgung zugeordnet ist, wobei die Messeinrichtung mit der Regel- und/oder Steuereinrichtung in Verbindung steht. Dabei kann in jeder Stromversorgung eine eigene Messeinrichtung angeordnet sein. Die Messeinrichtungen können jedoch auch an der Regel- und/oder Steuereinheit angeordnet sein, insbesondere in diese integriert sein. Eine separate Anordnung als eigenständige Bauteile ist ebenfalls denkbar. Jede DC-Stromversorgung kann in einem eigenen Gehäuse integriert sein, das mit Steckkontakten (Schnittstellen) für Eingangsspannungsanschlüsse, Ausgangsanschlüsse, sowie Mess-, Steuer- und Regelanschlüsse versehen ist. Dadurch ergibt sich eine schnelle Konfigurierbarkeit. Jede DC-Stromversorgung kann eine Regel- und/oder Steuereinrichtung in seinem Gehäuse aufnehmen, die die Aufgabe einer übergeordneten Steuerung übernimmt. Durch diese Maßnahme wird eine schnelle Konfigurierbarkeit und eine Austauschbarkeit der Regel- und/oder Steuereinrichtung erreicht.

Bei einer bevorzugten Ausführungsform weist die zumindest eine MF-Einheit zumindest einen zweiten Inverter auf, der mit zumindest einer DC-Stromversorgung verbunden ist, wobei die Ausgänge des ersten und zweiten Inverters zusammengeschaltet sind. Der erste und zweite Inverter liegen vorzugsweise nahe beieinander und sind symmetrisch aufgebaut. Erst an ihren Ausgängen sind sie induktionsarm zusammengeschaltet. Vorteilhafterweise werden sie von identischen Steuersignalen angesteuert. Auf diese Weise wird sichergestellt, dass sich keine Interferenzen ausbilden und keine Phasenverschiebung entsteht. Es können baugleiche Inverter verwendet werden, so dass die Produktionskosten gesenkt werden können. Es können Bauteile für niedrige Leistungen eingesetzt werden, wodurch Bauteilkosten reduziert werden. Die einfache Konfigurierbarkeit bleibt gewahrt, weil der zweite Inverter einfach stillgelegt werden kann, wenn an ihn keine DC-Stromversorgungen angeschlossen werden.

Bei einer Ausführungsform können mehrere an einen Netzanschluss anschließbare parallel geschaltete DC-Stromversorgungen zur Erzeugung einer zweiten Zwischenkreisspannung vorgesehen sein, die mit dem zweiten Inverter der MF-Einheit verbunden sind. Es ist auch denkbar, mehrere Gruppen mehrerer parallel geschalteter Stromversorgungen vorzusehen, wobei jede Gruppe mit einem Inverter verbunden ist und die Inverter vor einem Ausgangsschwingkreis zusammengeschaltet sind. Dadurch, dass die von den unterschiedlichen Gruppen erzeugten Zwischenkreisspannungen getrennt bleiben, können die DC-Stromversorgungen so geregelt werden, dass die Brücken der Inverter symmetrisch belastet werden. Dies wäre nicht möglich, wenn die Zwischenkreisspannungen zuerst zusammengeschlossen würden und anschließend wieder auf zwei Brücken verteilt würden.

Vorzugsweise weist jede DC-Stromversorgung eine Aufnahme für die Regel- und/oder Steuereinrichtung auf. Beispielsweise kann an dem Gehäuse eine Aufnahme oder ein Steckplatz ausgebildet sein. Somit kann jede Stromversorgung durch Aufnahme der Regel- und/oder Steuereinrichtung als Master-Stromversorgung ausgebildet werden, die dadurch eine übergeordnete Steuerung für alle Stromversorgungen aufweist. Sie sorgt für einen zuverlässigen Betrieb. Eine einzige Regel- und/oder Steuereinrichtung für alle DC-Stromversorgungen sorgt dafür, dass alle DC-Stromversorgungen die in etwa die gleiche Leistung abgeben. Damit kann zusätzlich sichergestellt werden, dass die Inverter gleichförmig belastet werden.

Vorteilhafterweise ist eine Arc-Erkennungseinrichtung vorgesehen. In Verbindung mit einer Arc-Unterdrückungs- und/oder Löscheinrichtung können Arcs, die beim MF-Sputtern sehr viel seltener auftreten als beim DC-Sputtern, schnell gelöscht werden und verursachen daher nur geringen Schaden. Insbesondere können geringe Arc-Restenergien sichergestellt werden (< 20mJ/kW). Vorzugsweise ist weiterhin ein Zeitglied (Timer) vorgesehen, das beim Auftreten eines Arcs eine Pause verstreichen lässt, in der die DC-Stromversorgung ausgeschaltet bleibt. Diese Pause kann im Bereich von 100µs bis 100ms einstellbar sein. Arcs können so sicher gelöscht werden, die Stromversorgung kann für unterschiedliche Prozesse unterschiedlich eingestellt werden. Weiterhin kann in der Arc-Löscheinrichtung eine Verzögerung einstellbar sein, mit der beim Erkennen eines Arcs verzögert mit dem Ausschalten der Stromversorgung reagiert wird. Dadurch wird die Möglichkeit geschaffen, Arcs, die auch nach Abschalten und Wiedereinschalten immer wieder auftreten, definiert abzubrennen.

In den Rahmen der Erfindung fällt außerdem eine Großflächen-Plasmabeschichtungsanlage, insbesondere zur Beschichtung/Herstellung von Flatpaneldisplays, mit den Merkmalen des Anspruchs 7. Der Frequenzbereich 20 - 500kHz und insbesondere der Bereich 20 - 100kHz lässt sich mit einfacher und günstiger Schaltungstechnik auch für hohe Leistungen (50 - 200kW) erzeugen. Er liegt außerhalb des hörbaren Bereichs, lärmstörende Schwingungen werden so vermieden. Er hat sich für eine homogene Plasmaverteilung als besonders vorteilhaft herausgestellt.

Überraschenderweise ist es mit dieser Vorgehensweise möglich, ein homogenes Plasma mit einer MF-Stromversorgung, d.h. einem Plasmaanregungssystem mit einer MF- Einheit, sehr viel besser und einfacher zu bewirken als mit DC-Stromversorgungen. Die mit den Elektroden verbundenen Targets werden sehr viel gleichmäßiger abgetragen, so dass die homogene Plasmaverteilung und damit die homogene Beschichtung auch über eine lange Betriebszeit sichergestellt werden kann.

Arcen tritt bei MF-Prozessen deutlich seltener auf, als bei DC-Prozessen. Um die mit dem seltenen Arcen verbundenen Probleme bei der Beschichtung weiter zu minimieren, kann vorgesehen sein, Arcs zu erkennen und beim Erkennen den Arc aktiv zu löschen oder zumindest die Stromversorgung(en) abzuschalten oder die Energiezufuhr von den Stromversorgungen in die Beschichtungskammer zu unterbinden, um die Arcs dadurch zum Erlöschen zu bringen. Nach einer Löschmaßnahme kann eine vorgegebene oder vorgebbare Zeit gewartet werden, bis das Plasma erneut gezündet wird bzw. die Leistungszufuhr in die Beschichtungskammer wieder erlaubt wird.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- **Fig. 1**: eine schematisierte Darstellung einer Großflächen-Plasmabeschichtungsanlage;
- **Fig. 2**: eine erste Ausführungsform eines Plasmaanregungssystems;
- **Fig. 3**: eine zweite Ausführungsform eines Plasmaanregungssystems.

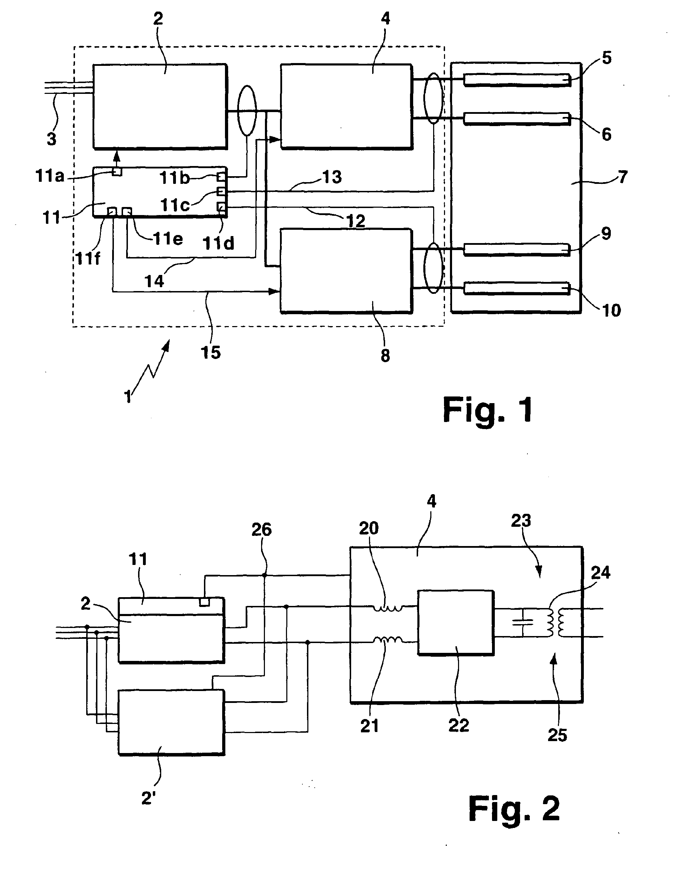

Die Fig. 1 zeigt ein Plasmaanregungssystem 1, das Teil einer Großflächen-Plasmabeschichtungsanlage ist. Im Plasmaanregungssystem 1 ist eine DC-Stromversorgung 2 angeordnet, die an einen Netzanschluss 3 angeschlossen ist. An die DC-Stromversorgung 2 ist eine erste MF-Einheit 4 angeschlossen. An die MF-Einheit 4 sind Elektroden 5, 6 angeschlossen, welche in einer Beschichtungskammer 7 angeordnet sind. Die Elektroden 5, 6 können jeweils mit einem oder mehreren Targets verbunden sein. Parallel zur MF-Einheit 4 ist eine zweite MF-Einheit 8 vorgesehen, die ebenfalls an die DC-Stromversorgung 2 angeschlossen ist. Der MF-Einheit 8 sind ebenfalls Elektroden 9, 10 zugeordnet, die in der Beschichtungskammer 7 angeordnet sind. Durch die Vielzahl von Elektroden 5, 6, 9, 10 ist es möglich, großflächige Werkstücke in der Beschichtungskammer 7 zu beschichten.

Es ist auch möglich, die Targets an den Elektroden 5, 6 und die Targets an den Elektroden 9, 10 mit unterschiedlichen Materialien auszustatten. Um eine gleichmäßige Beschichtung über der gesamten Fläche zu erzielen, müssten die Elektroden dann gleichmäßig verteilt sein.

Das Plasmaanregungssystem 1 weist weiterhin eine Regel- und/oder Steuereinrichtung 11 auf. Die Regel- und/oder Steuereinrichtung 11 hat als Eingangsgröße eine Ausgangsgröße der DC-Stromversorgung 2. Anhand dieser Ausgangsgröße wird die DC-Stromversorgung 2 geregelt bzw. gesteuert. Der Regel- und/oder Steuereinrichtung 11 sind weiterhin Messleitungen 12, 13 zugeführt, über die die Ausgangsgrößen der MF-Einheit 4, 8 erfasst und der Regel- und/oder Steuereinrichtung 11 zugeführt werden können. Durch die Regel- und/oder Steuereinrichtung 11 ist es ebenfalls möglich, die MF-Einheiten 4, 8 zu steuern. Dies ist durch die Steuerleitungen 14, 15 angedeutet. Die Messleitungen 12, 13 und Steuerleitungen 14, 15 können auch als Datenleitungen bezeichnet werden. An der Regel- und/oder Steuereinrichtung 11 sind Schnittstellen 11a - 11f vorgesehen, über die die DC-Stromversorgung und die MF-Einheiten 4, 8 bzw. die zur Verbindung verwendeten Leitungen 12 - 15 angeschlossen werden können.

In der Fig. 2 ist eine Ausführungsform des Plasmaanregungssystems 1 dargestellt. Es sind zwei DC-Stromversorgungen 2, 2' vorgesehen. Durch die DC-Stromversorgungen 2 und 2' wird eine Zwischenkreisspannung erzeugt, die über Drosseln 20,21 einem ersten Inverter 22 der MF-Einheit 4 zugeführt ist. Die DC-Stromversorgung 2 ist eine Master-DC-Stromversorgung und weist die Regel- und/oder Steuereinrichtung 11 auf. Die Regel- und/oder Steuereinrichtung 11 ist über Mess-, Daten-, Signal- und Steuerleitungen 26 mit der MF-Einheit 4 und der DC-Stromversorgung 2' verbunden. Der Inverter 22 speist einen Schwingkreis 23, der als Parallelschwingkreis ausgebildet ist. Die Spule 24 des Parallelschwingkreises 23 stellt die Primärinduktivität des Ausgangsübertragers 25 dar. Am Ausgang des Ausgangsübertragers 25 liegt eine MF-Spannung an.

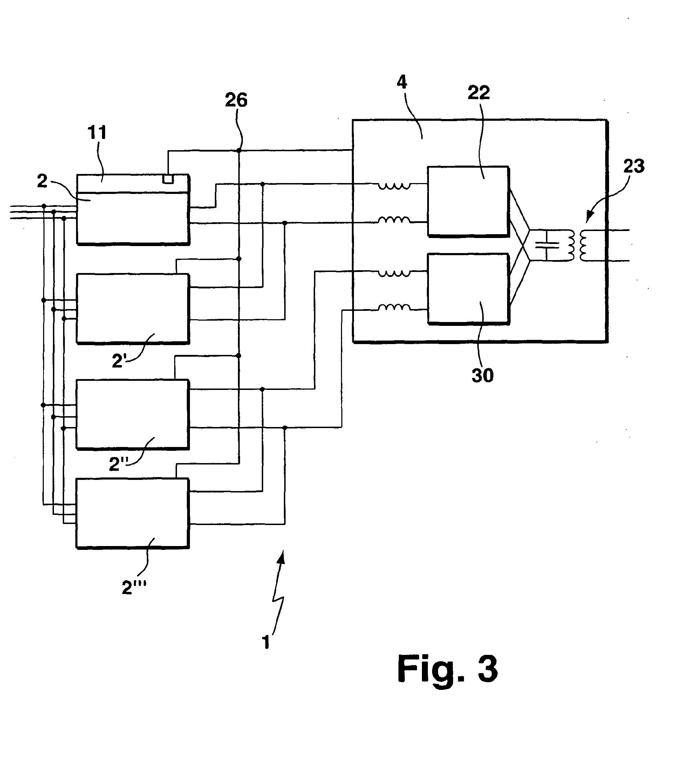

Die Fig. 3 zeigt ein alternatives Ausführungsbeispiel eines Plasmaanregungssystems 1. Jeweils zwei DC-Stromversorgungen 2, 2' bzw. 2", 2'" erzeugen eine Zwischenkreisspannung, die jeweils auf einen Inverter 22,30 gegeben wird. Die DC-Stromversorgung 2 ist wiederum die Master-Stromversorgung, die die Regel- und/oder Steuereinrichtung 11 aufweist. Die Regel- und/oder Steuereinrichtung 11 regelt und/oder steuert die DC-Stromversorgungen 2, 2', 2", 2'" und die MF-Einheit 4. Die Ausgänge der Inverter 22,30 sind induktionsarm zusammengeschaltet. Sie speisen den Ausgangsschwingkreis 23. Die DC-Stromversorgungen 2, 2', 2", 2'" werden so geregelt, dass sie alle in etwa die gleiche Leistung abgeben. Damit ist sichergestellt, dass die Inverter 22 und 30 symmetrisch belastet werden. Dies braucht in der MF Einheit nicht überwacht zu werden.

## Patentansprüche

1. Plasmaanregungssystem (1) zur Leistungsversorgung eines Plasmaprozesses mit zumindest einer an einen Netzanschluss (3) anschließbaren DC-Stromversorgung (2, 2', 2", 2"') und zumindest einer damit verbundenen Mittelfrequenz (MF) - Einheit (4, 8) zur Erzeugung einer AC-Spannung an ihrem Ausgang, wobei der Ausgang der MF-Einheit (4, 8) an Elektroden (5, 6, 9, 10) einer Beschichtungskammer (7) anschließbar ist, und mit einer Regel- und/oder Steuereinrichtung (11), die mit der zumindest einen DC-Stromversorgung (2, 2', 2", 2"') verbunden ist zur Regelung und/oder Steuerung einer Ausgangsgröße der DC-Stromversorgung (2, 2', 2", 2"') und die mit der zumindest einen MF-Einheit (4, 8) verbunden ist zur Regelung und/oder Steuerung einer Ausgangsgröße der MF-Einheit (4, 8), wobei die Regel- und/oder Steuereinrichtung (11) zumindest eine Eingangsschnittstelle (11c, 11d) zur Zuführung einer eine Ausgangsgröße der zumindest einen MF-Einheit (4, 8) beschreibenden Größe und zumindest eine Steuerausgangsschnittstelle (11e, 11f) zum Anschluss eines Steuereingangs der zumindest einen MF-Einheit (4, 8) aufweist, **dadurch gekennzeichnet, dass** mehrere an einen Netzanschluss (3) anschließbare parallele geschaltete DC-Stromversorgungen (2, 2') zur Erzeugung einer ersten Zwischenkreisspannung vorgesehen sind.

2. Plasmaanregungssystem nach Anspruch 1, **dadurch gekennzeichnet, dass** die zumindest eine MF-Einheit (4, 8) zumindest einen ersten Inverter (22) zur Speisung eines Ausgangsschwingkreises (23) aufweist, wobei die DC-Stromversorgungen (2, 2') mit dem ersten Inverter (22) der MF-Einheit (4) verbunden sind.

3. Plasmaanregungssystem nach einem der vorhergehenden Ansprüche, **dadurch gekennzeichnet, dass** jeder DC-Stromversorgung (2, 2', 2", 2"') eine Messeinrichtung zur Messung von Strom, Spannung und/oder Leistung am Ausgang der jeweiligen DC-Stromversorgung (2, 2', 2", 2"') zugeordnet ist, wobei die Messeinrichtung mit der Regel- und/oder Steuereinrichtung (11) in Verbindung steht, insbesondere an die entsprechende Eingangsschnittstelle der Regel- und/oder Steuereinrichtung (11) angeschlossen ist.

4. Plasmaanregungssystem nach einem der vorhergehenden Ansprüche, **dadurch gekennzeichnet, dass** die zumindest eine MF-Einheit (4, 8) zumindest einen zweiten Inverter (30) aufweist, der mit zumindest einer DC-Stromversorgung (2", 2"') verbunden ist, wobei die Ausgänge des ersten und zweiten Inverters (22, 30) zusammengeschaltet sind.

5. Plasmaanregungssystem nach einem der vorhergehenden Ansprüche, **dadurch gekennzeichnet, dass** mehrere an einen Netzanschluss (3) anschließbare parallel geschaltete DC-Stromversorgungen (2", 2"') zur Erzeugung einer zweiten Zwischenkreisspannung vorgesehen sind, die mit dem zweiten Inverter (30) der MF-Einheit (4) verbunden sind.

6. Plasmaanregungssystem nach einem der vorhergehenden Ansprüche, **dadurch gekennzeichnet, dass** jede DC-Stromversorgung (2, 2', 2", 2"') eine Aufnahme für die Regel- und/oder Steuereinrichtung (11) aufweist.

7. Großflächen-Plasmabeschichtungsanlage zur Beschichtung von Flatpaneldisplays, mit einem Plasmaanregungssystem (1) nach einem der vorhergehenden Ansprüche, einer Beschichtungskammer (7) mit mindestens zwei Elektroden (5, 6, 9, 10), die an das Plasmaanregungssystem (1) angeschlossen sind, wobei jede Elektrode (5, 6, 9, 10) mit zumindest einem Target verbunden ist, **dadurch gekennzeichnet, dass** die Beschichtungskammer (7) eine oder mehrere Substrathalterungen oder -aufnahmen aufweist, die zur Lagerung von Substraten mit einer Oberfläche ≥ 1 m² geeignet sind, wobei an dem oder den Ausgangsanschlüssen des Plasmaanregungssystems (1) eine AC-Spannung mit einer Frequenz im Bereich 20 - 500kHz, insbesondere 20 - 100kHz, und in der Beschichtungskammer (7) ein im Wesentlichen homogenes zweidimensionales Plasma erzeugbar ist.

## Claims

1. Plasma excitation system (1) for supplying power to a plasma process, comprising at least one DC current supply (2, 2', 2", 2"') which can be connected to a mains supply (3), at least one medium frequency (MF) unit (4, 8) connected to the DC current supply (2, 2', 2", 2"'), for generating an AC voltage at its output, wherein the output of the MF unit (4, 8) can be connected to electrodes (5, 6, 9, 10) of a coating chamber (7), and a regulation and/or control means (11) which is connected to the at least one DC current supply (2, 2', 2", 2"') for regulating and/or controlling an output value of the DC current supply (2, 2', 2", 2"'), and is also connected to the at least one MF unit (4, 8) for regulating and/or controlling an output value of the MF unit (4, 8), wherein the regulation and/or control means (11) comprises at least one input interface (11c, 11d) for supplying a value describing an output value of the at least one MF unit (4, 8), and at least one control output interface (11e, 11f) for connecting a control input of the at least one MF unit (4, 8), **characterized in that** several DC current supplies (2, 2') which are connected in parallel and can be connected to a mains supply (3) are provided for generating a first intermediate circuit voltage.

2. Plasma excitation system according to claim 1, **characterized in that** the at least one MF unit (4, 8) comprises at least one first inverter (22) for feeding an output oscillating circuit (23), wherein the DC current supplies (2, 2') are connected to the first inverter (22) of the MF unit (4).

3. Plasma excitation system according to any one of the preceding claims, **characterized in that** a measuring means for measuring the current, voltage and/or power at the output of the respective DC current supply (2, 2', 2", 2"') is allocated to each DC current supply (2, 2', 2", 2"'), wherein the measuring means is connected to the regulation and/or control means (11), in particular, to the corresponding input interface of the regulation and/or control means (11).

4. Plasma excitation system according to any one of the preceding claims, **characterized in that** the at least one MF unit (4, 8) comprises at least one second inverter (30) which is connected to at least one DC current supply (2", 2"'), wherein the outputs of the first and second inverter (22, 30) are interconnected.

5. Plasma excitation system according to any one of the preceding claims, **characterized in that** several DC current supplies (2", 2"'), which are connected in parallel and can be connected to a mains supply (3), are provided for generating a second intermediate circuit voltage, and are connected to the second inverter (30) of the MF unit (4).

6. Plasma excitation system according to any one of the preceding claims, **characterized in that** each DC current supply (2, 2',2", 2"') comprises a receptacle for the regulation and/or control means (11).

7. Large-surface plasma coating system for coating flat panel displays, comprising a plasma excitation system (1) according to any one of the preceding claims, a coating chamber (7) with at least two electrodes (5, 6, 9, 10) which are connected to the plasma excitation system (1), wherein each electrode (5, 6, 9, 10) is connected to at least one target, **characterized in that** the coating chamber (7) comprises one or more substrate holders or receptacles which are suited for supporting substrates of a surface ≥ 1 square meter, wherein an AC voltage with a frequency in the range between 20 and 500 kHz, in particular 20 and 100 kHz, can be generated at the output connection/s of the plasma excitation system (1), and a substantially homogeneous two-dimensional plasma can be generated in the coating chamber (7).

## Revendications

1. Système d'excitation de plasma (1) pour l'alimentation en puissance d'un procédé plasma avec au moins une alimentation en courant continu (2, 2', 2", 2"') pouvant être raccordée à un raccordement au secteur (3) et au moins une unité moyenne fréquence (MF) (4, 8) connectée à celle-ci pour générer une tension alternative à sa sortie, la sortie de l'unité MF (4, 8) pouvant être raccordée à des électrodes (5, 6, 9, 10) d'une chambre de revêtement (7), et avec un dispositif de régulation et/ou de commande (11) qui est connecté à ladite au moins une alimentation en courant continu (2, 2', 2", 2"') pour la régulation et/ou la commande d'une grandeur de sortie de l'alimentation en courant continu (2, 2', 2", 2"') et qui est connecté à ladite au moins une unité MF (4, 8) pour la régulation et/ou la commande d'une grandeur de sortie de l'unité MF (4, 8), le dispositif de régulation et/ou de commande (11) présentant au moins une interface d'entrée (11c, 11d) pour l'amenée d'une grandeur décrivant une grandeur de sortie de ladite au moins une unité MF (4, 8) et au moins une interface de sortie de commande (11e, 11f) pour le raccordement d'une entrée de commande de ladite au moins une unité MF (4, 8), **caractérisé en ce qu'**il est prévu plusieurs alimentations en courant continu (2, 2') branchées en parallèle, pouvant être raccordées à un raccordement au secteur (3), pour générer une première tension de circuit intermédiaire.

2. Système d'excitation de plasma selon la revendication 1, **caractérisé en ce que** ladite au moins une unité MF (4, 8) présente au moins un premier convertisseur (22) pour alimenter un circuit oscillant de sortie (23), les alimentations en courant continu (2, 2') étant connectées au premier convertisseur (22) de l'unité MF (4).

3. Système d'excitation de plasma selon une des revendications précédentes, **caractérisé en ce qu'**à chaque alimentation en courant continu (2, 2', 2", 2"') est associé un dispositif de mesure pour la mesure de courant, tension et/ou puissance à la sortie de l'alimentation en courant continu (2, 2', 2", 2"') respective, le dispositif de mesure étant connecté au dispositif de régulation et/ou de commande (11), en particulier à l'interface d'entrée correspondante du dispositif de régulation et/ou de commande (11).

4. Système d'excitation de plasma selon une des revendications précédentes, **caractérisé en ce que** ladite au moins une unité MF (4, 8) présente au moins un deuxième convertisseur (30) qui est connecté à au moins une alimentation en courant continu (2", 2"'), les sorties du premier et du deuxième convertisseur (22, 30) étant interconnectées.

5. Système d'excitation de plasma selon une des revendications précédentes, **caractérisé en ce qu'**il est prévu plusieurs alimentations en courant continu (2", 2"') branchées en parallèle, pouvant être raccordées à un raccordement au secteur (3), pour générer une deuxième tension de circuit intermédiaire, lesquelles sont connectées au deuxième convertisseur (30) de l'unité MF (4).

6. Système d'excitation de plasma selon une des revendications précédentes, **caractérisé en ce que** chaque alimentation en courant continu (2, 2', 2", 2"') présente un logement pour le dispositif de régulation et/ou de commande (11).

7. Système de revêtement par plasma de grandes surfaces destiné au revêtement d'écrans plats, avec un système d'excitation de plasma (1) selon une des revendications précédentes, une chambre de revêtement (7) avec au moins deux électrodes (5, 6, 9, 10) qui sont raccordées au système d'excitation de plasma (1), chaque électrode (5, 6, 9, 10) étant connectée à au moins une cible, **caractérisé en ce que** la chambre de revêtement (7) présente un ou plusieurs supports ou logements de substrat qui permettent le montage de substrats d'une surface ≥ 1 m², une tension alternative d'une fréquence comprise dans la plage 20 - 500 kHz, en particulier 20 - 100 kHz pouvant être générée au(x) raccordement(s) de sortie du système d'excitation de plasma (1) et un plasma bidimensionnel essentiellement homogène pouvant être généré dans la chambre de revêtement (7).
